# EUROPEAN PATENT SPECIFICATION

(11) **EP 4 546 407 B1**
(45) Date of publication and mention of the grant of the patent: **18.03.2026**
(21) Application number: 24178654.0
(22) Date of filing: 29.05.2024
(51) Int. Cl.: H01L 21/768, H01L 23/522, H01L 23/528, H01L 23/532

(54) **SEMICONDUCTOR CHIP**
HALBLEITERCHIP
PUCE SEMI-CONDUCTRICE

(30) Priority: 24.10.2023 KR 20230143183
(43) Date of publication of application: 30.04.2025
(73) Proprietor: Samsung Electronics Co., Ltd., Suwon-si, Gyeonggi-do 16677 (KR)
(72) Inventor: LEE, Juik, 16677 Suwon-si, Gyeonggi-do (KR); LEE, Nara, 16677 Suwon-si, Gyeonggi-do (KR); LEE, Jong-Min, 16677 Suwon-si, Gyeonggi-do (KR)
(74) Representative: Kuhnen & Wacker Patent- und Rechtsanwaltsbüro PartG mbB

(56) References cited:
- US-A1- 2010 301 488
- US-A1- 2018 277 517
- US-A1- 2020 303 268
- US-A1- 2022 336 326
- US-A1- 2022 367 320
- US-A1- 2023 076 238
- US-A1- 2023 080 862

## Description

### BACKGROUND OF THE INVENTION

The inventive concept relates to a semiconductor chip.

A semiconductor package is configured to easily use an integrated circuit chip as a part of an electronic product. Conventionally, the semiconductor package includes a printed circuit board (PCB) and a semiconductor chip die, which is mounted on the PCB and is electrically connected to the PCB using bonding wires or bumps. With development of the electronics industry, many studies are being conducted to improve reliability and durability of semiconductor packages.

US2023/0076238 A1 discloses a semiconductor chip according to the preamble of claim 1.

### SUMMARY

An object of the inventive concept is to provide a semiconductor chip with improved reliability.

A semiconductor chip according to some embodiments of the inventive concept includes a substrate, a first interlayer insulating layer, a porous insulating layer, and a second interlayer insulating layer sequentially stacked on the substrate, lower pads on the second interlayer insulating layer and having a first thickness in a vertical direction, third and fourth interlayer insulating layers sequentially stacked on the lower pads and the second interlayer insulating layer, an upper pad on the fourth interlayer insulating layer and having a second thickness in the vertical direction greater than the first thickness, and via structures in the fourth interlayer insulating layer and the third interlayer insulating layer and electrically connecting the lower pads and the upper pad, wherein each of the via structures includes a first via in the third interlayer insulating layer and a second via in the fourth interlayer insulating layer and overlapping the first via in the vertical direction.

A semiconductor chip according to some embodiments of the inventive concept includes a substrate, a first interlayer insulating layer, a porous insulating layer, and a second interlayer insulating layer sequentially stacked on the substrate, a through via in the first interlayer insulating layer and the substrate, a via insulating layer interposed between the through via and the substrate, wirings in the porous insulating layer, a contact plug in the first interlayer insulating layer and in contact with one of the wirings, lower pads on the second interlayer insulating layer and having a first thickness in a vertical direction, third and fourth interlayer insulating layers sequentially stacked on the lower pads and the second interlayer insulating layer, an upper pad on the fourth interlayer insulating layer and having a second thickness in the vertical direction greater than the first thickness, and via structures in the fourth interlayer insulating layer and the third interlayer insulating layer and electrically connecting the lower pads and the upper pad, wherein the third interlayer insulating layer includes a first silicon oxide layer, a hydrogen barrier layer, and a second silicon oxide layer that are sequentially stacked, each of the via structures includes a first via that is in the third interlayer insulating layer and a second via that is in the fourth interlayer insulating layer and overlaps the first via in the vertical direction, and each of the via structures has a height of 1.0 *µ*m to 10 *µ*m in the vertical direction.

### BRIEF DESCRIPTION OF THE DRAWINGS

Example embodiments will be more clearly understood from the following brief description taken in conjunction with the accompanying drawings. The accompanying drawings represent non-limiting, example embodiments as described herein.
FIG. 1 is a cross-sectional view of a semiconductor chip according to embodiments of the inventive concept.
FIGS. 2A to 2C show plan views of a landing pad and an upper pad according to embodiments of the inventive concept.
FIG. 3 is a cross-sectional view of a semiconductor chip according to embodiments of the inventive concept.
FIG. 4 is a cross-sectional view of a semiconductor chip according to embodiments of the inventive concept.
FIG. 5 is a cross-sectional view of a semiconductor chip according to embodiments of the inventive concept.
FIG. 6 is a cross-sectional view of a semiconductor chip according to embodiments of the inventive concept.
FIG. 7 is a cross-sectional view of a semiconductor chip according to embodiments of the inventive concept.
FIG. 8 is a cross-sectional view of a semiconductor chip according to embodiments of the inventive concept.
FIG. 9A is a cross-sectional view of a semiconductor package with a semiconductor chip according to embodiments of the inventive concept.
FIG. 9B is an enlarged view of portion 'P2' of FIG. 9A.
FIGS. 10A to 10G are views sequentially showing a method of manufacturing the semiconductor chip of FIG. 1.

### DETAILED DESCRIPTION

Hereinafter, to explain the inventive concept in detail, embodiments according to the inventive concept will be described with reference to the accompanying drawings. Herein, terms indicating order such as first, second, etc. are used to distinguish components that perform the same/similar functions, and their numbers may change depending on the order in which they are mentioned.

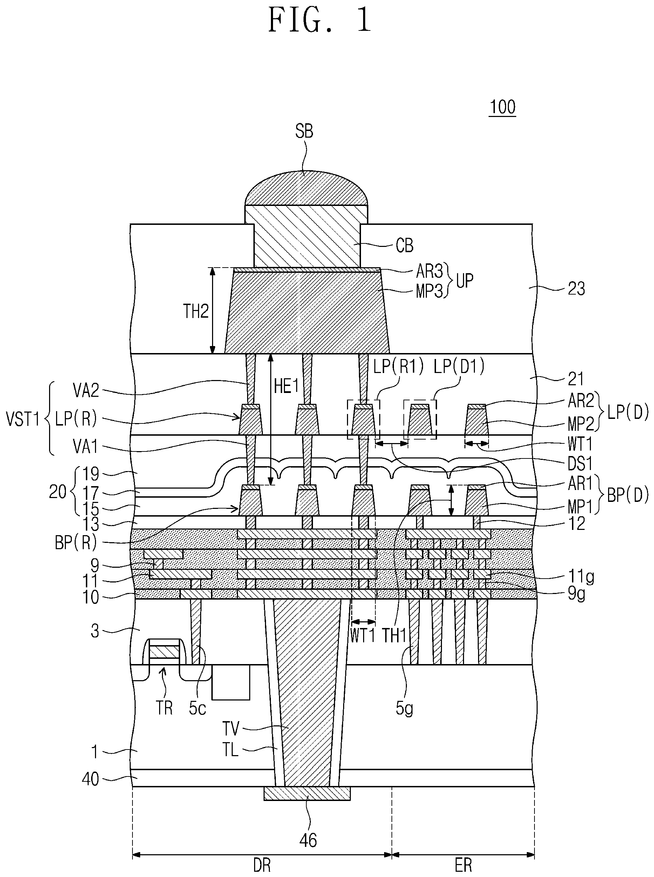

FIG. 1 is a cross-sectional view of a semiconductor chip according to embodiments of the inventive concept.

Referring to FIG. 1, a semiconductor chip 100 according to the present example may include a substrate 1. In this specification, 'semiconductor chip' may also be referred to as 'semiconductor die'. The substrate 1 may include, for example, a semiconductor material. The substrate 1 may be a silicon single crystal substrate. The substrate 1 may include a first region DR and a second region ER. For example, the first region DR may be a device region where integrated circuits and through vias are disposed. The second region ER may be a dummy region or an edge region.

Transistors TR may be disposed on a front surface of the substrate 1 in the first region DR. Although not shown, shallow device isolation patterns, memory cells, capacitors, etc. may be disposed on the front surface of the substrate 1 in the first region DR. The memory cells may include word lines and bit lines.

The front surface of the substrate 1 may be covered with a first interlayer insulating layer 3. The first interlayer insulating layer 3 may cover the transistors TR, memory cells, capacitors, etc. For example, the first interlayer insulating layer 3 may have a single-layer or multi-layer structure of at least one of silicon oxide, silicon nitride, and silicon oxynitride. First contacts (e.g., contact plugs) 5c electrically connected to the transistors TR may be disposed in the first interlayer insulating layer 3 on the first region DR. For example, a first contact 5c may be in contact with a first wiring 11. Second contacts 5g may be disposed in the first interlayer insulating layer 3 on the second region ER. According to one example, each of the second contacts 5g may be a dummy pattern, a guard ring pattern, a chipping dam pattern, or a test pattern. The guard ring pattern or chipping dam pattern may serve to protect the first region DR from moisture or physical cracks. The guard ring pattern or chipping dam pattern may have a closed curve shape surrounding the first region DR when viewed in a plan view.

Multilayer porous insulating layers 10 are stacked on the first interlayer insulating layer 3. Each of the porous insulating layers 10 may be formed of a low-k material having a dielectric constant smaller than that of silicon oxide. Each of the porous insulating layers 10 may have a density less than that of the first interlayer insulating layer 3. A mechanical strength of each of the porous insulating layers 10 may be less than a mechanical strength of the first interlayer insulating layer 3. Each of the porous insulating layers 10 may include carbon. Each of the porous insulating layers 10 may include SiOCH. Although not shown, a silicon nitride layer or SiCN layer may be interposed between the porous insulating layers 10.

First vias 9 and first wirings 11 are disposed in the porous insulating layers 10 in the first region DR. Second vias 9g and second wirings 11g are disposed in the porous insulating layers 10 in the second region ER. Each of the first vias 9, first wirings 11, second vias 9g, and second wirings 11g may include copper. Side surfaces and a lower surface of each of the first vias 9, first wirings 11, second vias 9g, and second wirings 11g may be covered with a diffusion barrier layer. The diffusion barrier layer may include at least one of titanium, tantalum, titanium nitride, and tantalum nitride. At least one of the first vias 9, first wirings 11, second vias 9g, and second wirings 11g may have a dual damascene pattern structure.

Each of the second vias 9g and the second wirings 11g may be a dummy pattern, a guard ring pattern, a chipping dam pattern, or a test pattern. The guard ring pattern or chipping dam pattern may serve to protect the first region DR from moisture or physical cracks. The guard ring pattern or chipping dam pattern may have a closed curve shape surrounding the first region DR when viewed in a plan view.

The back surface of the substrate 1 is covered with a lower passivation layer 40. The lower passivation layer 40 may have a single-layer or multi-layer structure of at least one of silicon oxide, silicon nitride, SiCN, and polyimide.

In the first region DR, a through via TV may penetrate the substrate 1, the lower passivation layer 40, and the first interlayer insulating layer 3 and may be in contact with one of the first wirings 11. As used herein, the term "contact" refers to direct, physical contact. The through via TV may be electrically connected to at least one of the transistors TR by some of the first wirings 11.

The through via TV may include copper or tungsten. A side surface of the through via TV may be covered with a diffusion barrier layer. The diffusion barrier layer may include at least one of titanium, tantalum, titanium nitride, and tantalum nitride. A via insulating layer TL may be interposed between the through via TV and the substrate 1. The via insulation layer TL may have a single-layer or multi-layer structure of at least one of silicon oxide, silicon nitride, and silicon oxynitride. The via insulating layer TL may include an air gap region therein.

A lower conductive bump 46 is disposed below the lower passivation layer 40 and is in contact with the through via TV. The lower conductive bump 46 may include at least one of copper, aluminum, nickel, and gold.

The uppermost one of the porous insulating layers 10 may be covered with a second interlayer insulating layer 13. The second interlayer insulating layer 13 may be formed of silicon oxide. Third vias 12 may be disposed in the second interlayer insulating layer 13. The third vias 12 may include copper or tungsten.

Lower pads BP are disposed on the second interlayer insulating layer 13. The lower pads BP may include first lower pads BP(R) and second lower pads BP(D). Each of the lower pads BP may also be called a 'lower wiring'. Each of the lower pads BP may have a first thickness TH1 in a vertical direction (e.g., a direction perpendicular to an uppermost surface of the substrate 1). The first thickness TH1 may be, for example, 0.1 micrometers (µm) to 1 µm. Each of the lower pads BP may have a wider width in a lateral direction (e.g., a direction parallel to an uppermost surface of the substrate 1) as the lower pad BP goes downward in the vertical direction. A lower surface of each of the lower pads BP may have a first width WT1 in the lateral direction. A distance between the lower pads BP in the lateral direction may be the same. In another example, a distance between the first lower pads BP(R) may be different from a distance between the second lower pads BP(D). A width of the first lower pads BP(R) may be different from a width of the second lower pads BP(D).

An actual electrical signal may be applied to the first lower pads BP(R). A dummy pattern of the second lower pads BP(D) may be electrically floating. Each of the second lower pads BP(D) may be a dummy pattern, a guard ring pattern, a chipping dam pattern, or a test pattern. Each of the lower pads BP may include a first metal portion MP1 and a first anti-reflection layer AR1 that are sequentially stacked. The first metal portion MP1 may be formed of aluminum, for example. The first anti-reflection layer AR1 may be formed as a single layer or a multilayer of at least one of, for example, titanium, titanium nitride, tantalum, or tantalum nitride.

The lower pads BP and the second interlayer insulating layer 13 may be covered with a third interlayer insulating layer 20. The third interlayer insulating layer 20 may include a first silicon oxide layer 15, a hydrogen barrier layer 17, and a second silicon oxide layer 19 that are sequentially stacked. The hydrogen barrier layer 17 may be formed of, for example, silicon nitride. The first silicon oxide layer 15 may fill a space between the lower pads BP. An upper surface of the first silicon oxide layer 15 may have a concavo-convex structure. The hydrogen barrier layer 17 may have a conformal thickness. An upper surface of the hydrogen barrier layer 17 may also have a concavo-convex structure. An upper surface of the second silicon oxide layer 19 may be flat. The hydrogen barrier layer 17 may impede/prevent hydrogen from diffusing into the transistors or the memory cells, thereby improving reliability of the semiconductor chip.

A fourth interlayer insulating layer 21 is disposed on the third interlayer insulating layer 20. The fourth interlayer insulating layer 21 may have a single-layer or multi-layer structure of at least one of silicon oxide and silicon nitride. The fourth interlayer insulating layer 21 may have a flat upper surface.

An upper pad UP is disposed on the fourth interlayer insulating layer 21. The upper pad UP may have a second thickness TH2 in the vertical direction. The second thickness TH2 is greater than the first thickness TH1. The second thickness TH2 may be 2 to 5 times the first thickness TH1. The second thickness TH2 may be, for example, 2 µm to 2.5 µm.

The upper pad UP may include a conductive material. The upper pad UP may include a third metal portion MP3 and a third anti-reflection layer AR3 that are sequentially stacked. The third metal portion MP3 may be formed of aluminum, for example. The third anti-reflection layer AR3 may be formed as a single layer or a multilayer of at least one of, for example, titanium, titanium nitride, tantalum, or tantalum nitride. The upper pad UP may have a wider width as the upper pad UP goes downward.

A first via structure VST1 extends in (e.g., penetrates) the third interlayer insulating layer 20 and the fourth interlayer insulating layer 21 to electrically connect the first lower pads BP(R) to the upper pad UP. The first via structure VST1 may have a first height HE1 in the vertical direction. The first height HE1 is a vertical distance from a lowermost surface of the first via structure VST1 to an uppermost surface of the first via structure VST1. The first height HE1 may be equal to or greater than the second thickness TH2. The first height HE1 may be, for example, 1.0 µm to 10 µm. Accordingly, the upper pad UP may be spaced apart from the first lower pads BP(R) by a certain (e.g., predetermined) distance, thereby reducing parasitic capacitance between the first wirings 11 by a voltage applied to the upper pad UP and improving resistance capacitance (RC) delay characteristics.

A plurality of first via structures VST1 may be provided. Each of the first via structures VST1 may include a first via VA1, a first landing pad LP(R), and a second via VA2 that are sequentially stacked. The first via VA1 extends in (e.g., penetrates) the third interlayer insulating layer 20 and is in contact with the first lower pad BP(R). The second via VA2 extends in (e.g., penetrates) the fourth interlayer insulating layer 21 to electrically connect the first landing pad LP(R) to the upper pad UP. The second via VA2 may overlap the first landing pad LP(R) and the first via VA1 in the vertical direction. Accordingly, a vertical axis may pass through the second via VA2, the first landing pad LP(R), and the first via VA1. The first via VA1 and the second via VA2 may include tungsten. A side surface and a lower surface of each of the first via VA1 and the second via VA2 may be covered with a diffusion barrier layer.

Second landing pads LP(D) may be disposed on the third interlayer insulating layer 20 in the second region ER. The second landing pads LP(D) may also be called 'dummy pads.' The second landing pads LP(D) may be a dummy pattern that is not electrically connected to any first via VA1 or second via VA2 of any of the first via structures VST1. The second landing pads LP(D) may impede/prevent a loading effect to help the first landing pads LP(R) be formed accurately.

The first landing pads LP(R) and the second landing pads LP(D) may constitute pads LP. Each of the landing pads LP may have a wider width as the landing pad LP goes downward. Each of the landing pads LP may include a second metal portion MP2 and a second anti-reflection layer AR2 that are sequentially stacked. The second metal portion MP2 may be formed of aluminum, for example. The second anti-reflection layer AR2 may be formed of, for example, a single layer or a multilayer of at least one of titanium, titanium nitride, tantalum, or tantalum nitride. Each of the landing pads LP may have the same first thickness TH1 as the lower pads BP. Alternatively, a thickness of each of the landing pads LP may be greater than the first thickness TH1. A lower surface of each of the landing pads LP may have the first width WT1 in the lateral direction.

The landing pads LP may be spaced apart from each other by the same first distance DS1 in the lateral direction. That is, the first landing pads LP(R) may be spaced apart from each other by the same first distance DS1. The second landing pads LP(D) may be spaced apart from each other by the same first distance DS1. Among the first landing pads LP(R), the outermost first landing pad LP(R1) closest to the second landing pads LP(D) may be spaced apart from the outermost second landing pad LP(D1) adjacent thereto by the first distance DS1. Accordingly, the second landing pads LP(D) may be formed with the same size and spacing-distance as the first landing pads LP(R), thereby impeding/preventing loading effect. In another example, the distance between the first landing pads LP(R) may be different from the distance between the second landing pads LP(D). A width of the first landing pads LP(R) may be different from a width of the second landing pads LP(D).

The fourth interlayer insulating layer 21 and the upper pad UP may be overlapped by (e.g., covered with) an upper passivation layer 23. The upper passivation layer 23 may have a single-layer or multi-layer structure of at least one of silicon oxide, silicon nitride, SiCN, and polyimide.

An upper conductive bump CB may penetrate the upper passivation layer 23 and may be in contact with the upper pad UP. The upper conductive bump CB may include copper. A solder layer SB is bonded on the upper conductive bump CB. The solder layer SB may include SnAg, for example.

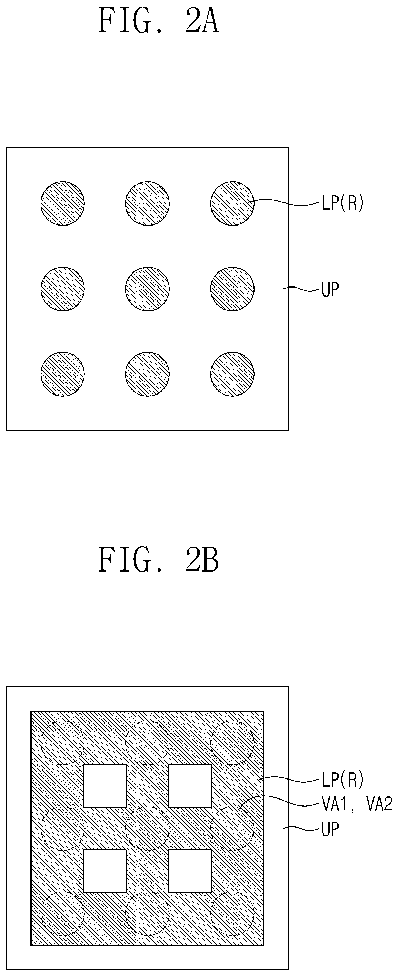

FIGS. 2A to 2C show plan views of a landing pad and an upper pad according to embodiments of the inventive concept.

Referring to FIGS. 1 and 2A, the first landing pads LP(R) may have a shape of islands (e.g., circles) spaced apart from each other.

Referring to FIGS. 1 and 2B, the first landing pads LP(R) may be electrically connected to each other to collectively have a grid (e.g., perforated, rectangular) shape.

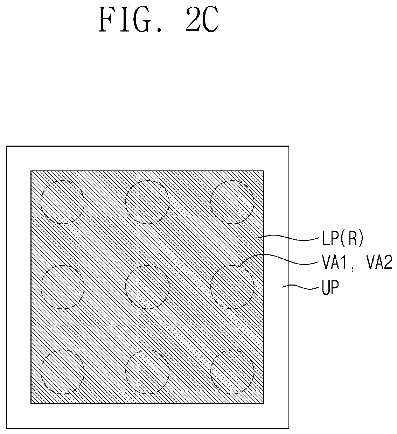

Alternatively, referring to FIGS. 1 and 2C, the first landing pads LP(R) may be electrically connected to each other and collectively have a plate (e.g., non-perforated, rectangular) shape.

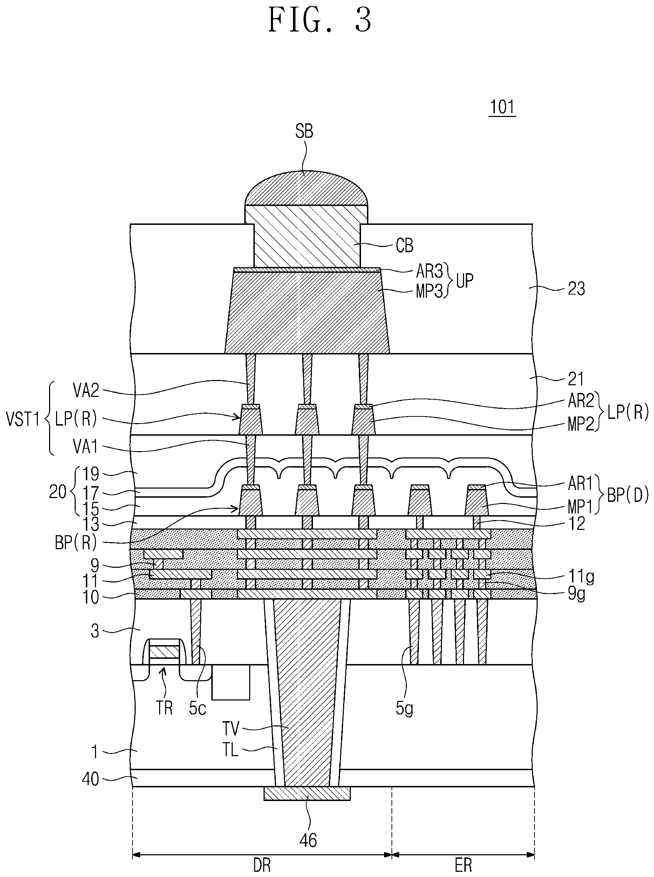

FIG. 3 is a cross-sectional view of a semiconductor chip according to embodiments of the inventive concept.

Referring to FIG. 3, a semiconductor chip 101 according to the present example may exclude (i.e., omit) the second landing pads LP(D) of FIG. 1. Other structures may be the same as those in FIG. 1.

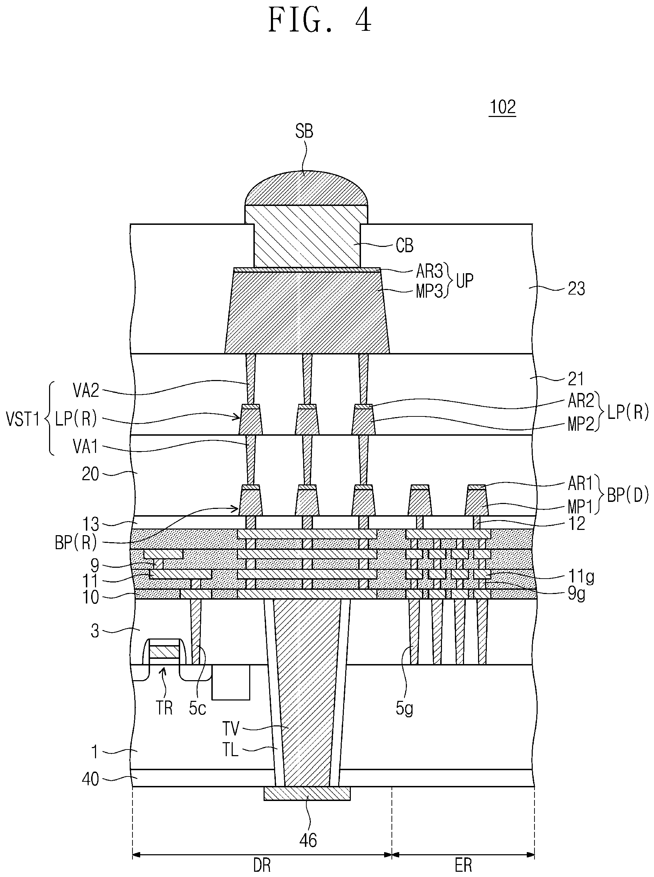

FIG. 4 is a cross-sectional view of a semiconductor chip according to embodiments of the inventive concept.

Referring to FIG. 4, in a semiconductor chip 102 according to the present example, a third interlayer insulating layer 20 may be formed of a single layer of silicon oxide (and thus may not have the hydrogen barrier 17 between first and second silicon oxide layers 15 and 19). A fourth interlayer insulating layer 21 may also be formed of a single layer of silicon oxide (and thus may not have the hydrogen barrier 17 between first and second silicon oxide layers 15 and 19). The third interlayer insulating layer 20 and the fourth interlayer insulating layer 21 may be formed of the same silicon oxide layer, and thus an interface therebetween may not be distinguished. The silicon oxide layer may have a lower dielectric constant than that of silicon nitride and the structure of FIG. 4 may be reduce parasitic capacitance between the upper pad UP and the lower pads BP, thereby improving RC delay characteristics. Other structures may be the same/similar to those of FIG. 3.

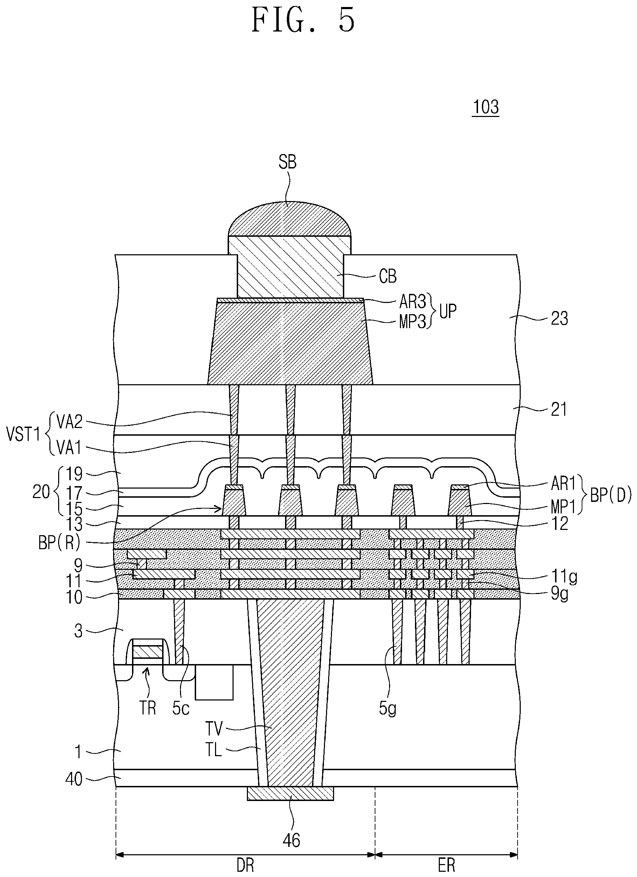

FIG. 5 is a cross-sectional view of a semiconductor chip according to embodiments of the inventive concept.

Referring to FIG. 5, in a semiconductor chip 103 according to the present example, the first via structure VST1 may exclude (i.e., omit) the first landing pad LP(R). In the present example, the first via structure VST1 includes only the first via VA1 and the second via VA2. The first via VA1 and the second via VA2 are in contact with each other. There may be no interface between the first via VA1 and the second via VA2. The first via VA1 and the second via VA2 may be formed integrally with each other. The first via VA1 and the second via VA2 may have a width in the lateral direction that narrows downward. A portion of an upper surface of the first via VA1 may protrude in the lateral direction beyond a lower surface of the second via VA2, and may be vertically overlapped by (e.g., covered and/or in contact with) the fourth interlayer insulating layer 21. Other structures may be the same/similar to those of FIG. 3.

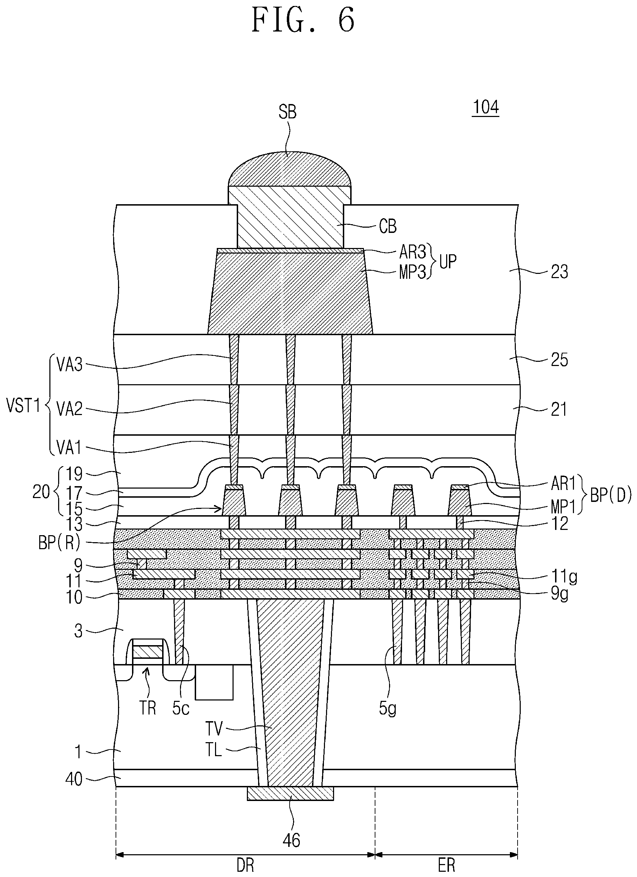

FIG. 6 is a cross-sectional view of a semiconductor chip according to embodiments of the inventive concept.

Referring to FIG. 6, a semiconductor chip 104 according to the present example may further include a fifth interlayer insulating layer 25 interposed between the fourth interlayer insulating layer 21 and the upper passivation layer 23. The fifth interlayer insulating layer 25 may be formed of silicon oxide. The first via structure VST1 extends in (e.g., penetrates) the third to fifth interlayer insulating layers 20, 21, and 25. The first via structure VST1 may exclude the first landing pad LP(R). In the present example, the first via structure VST1 includes a first via VA1, a second via VA2, and a third via VA3 that are sequentially stacked. The third via VA3 extends in (e.g., penetrates) the fifth interlayer insulating layer 25. The first via VA1 and the second via VA2 are in contact with each other. The second via VA2 and the third via VA3 are in contact with each other. There may be no interface between the first via VA1 and the second via VA2. There may be no interface between the second via VA2 and the third via VA3. The first via VA1, the second via VA2, and the third via VA3 may be formed integrally with each other. The first via VA1, the second via VA2, and the third via VA3 may have a width that narrows downward. A portion of an upper surface of the first via VA1 may be vertically overlapped by (e.g., covered with) the fourth interlayer insulating layer 21. A portion of an upper surface of the second via VA2 may be vertically overlapped by (e.g., covered with) the fifth interlayer insulating layer 25. Other structures may be the same/similar to those of FIG. 3.

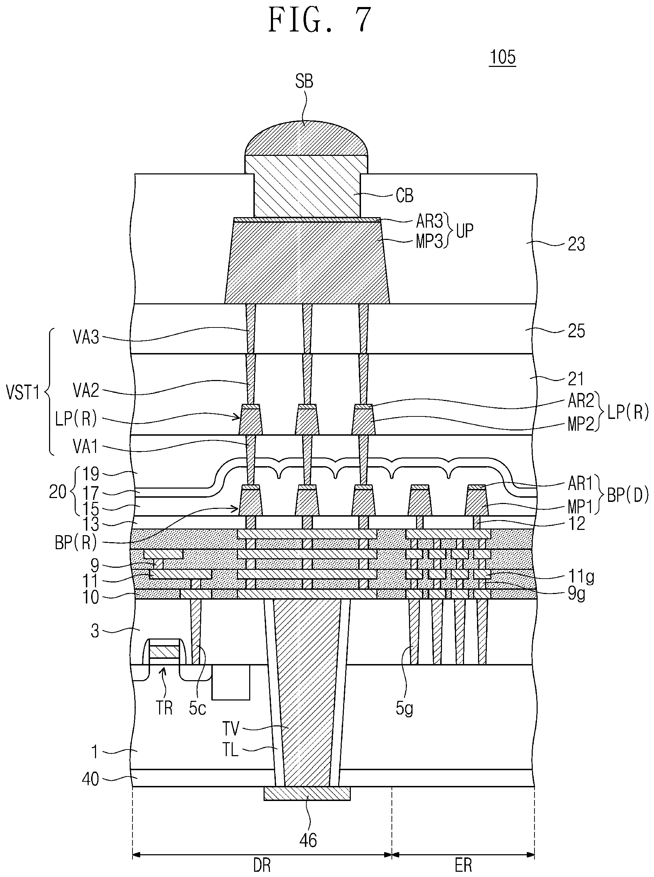

FIG. 7 is a cross-sectional view of a semiconductor chip according to embodiments of the inventive concept.

Referring to FIG. 7, a semiconductor chip 105 according to the present example may further include a fifth interlayer insulating layer 25 interposed between the fourth interlayer insulating layer 21 and the upper passivation layer 23. The fifth interlayer insulating layer 25 may be formed of silicon oxide. The first via structure VST1 extends in (e.g., penetrates) the third to fifth interlayer insulating layers 20, 21, and 25. In the present example, the first via structure VST1 includes a first via VA1, a first landing pad LP(R), a second via VA2, and a third via VA3 that are sequentially stacked. The third via VA3 penetrates the fifth interlayer insulating layer 25. The second via VA2 and the third via VA3 are in contact with each other. There may be no interface between the second via VA2 and the third via VA3. The second via VA2 and the third via VA3 may be formed integrally with each other. The first via VA1, the second via VA2, and the third via VA3 may have a width that narrows downward. A portion of an upper surface of the second via VA2 may be vertically overlapped by (e.g., covered with) the fifth interlayer insulating layer 25. Other structures may be the same/similar to those of FIG. 6. In this example, the first via structure VST1 includes vias in a three-tier structure, but is not limited thereto and may include vias in four or more tiers.

In another example, the first via structure VST1 may further include a first landing pad LP(R) interposed between the second via VA2 and the third via VA3. Accordingly, the first via structure VST1 may include a first via VA1, a first landing pad LP(R), a second via VA2, a first landing pad LP(R), and a third via VA3 that are sequentially stacked. Alternatively, the first via structure VST1 may include a first via VA1, a second via VA2, a first landing pad LP(R), and a third via VA3 that are sequentially stacked.

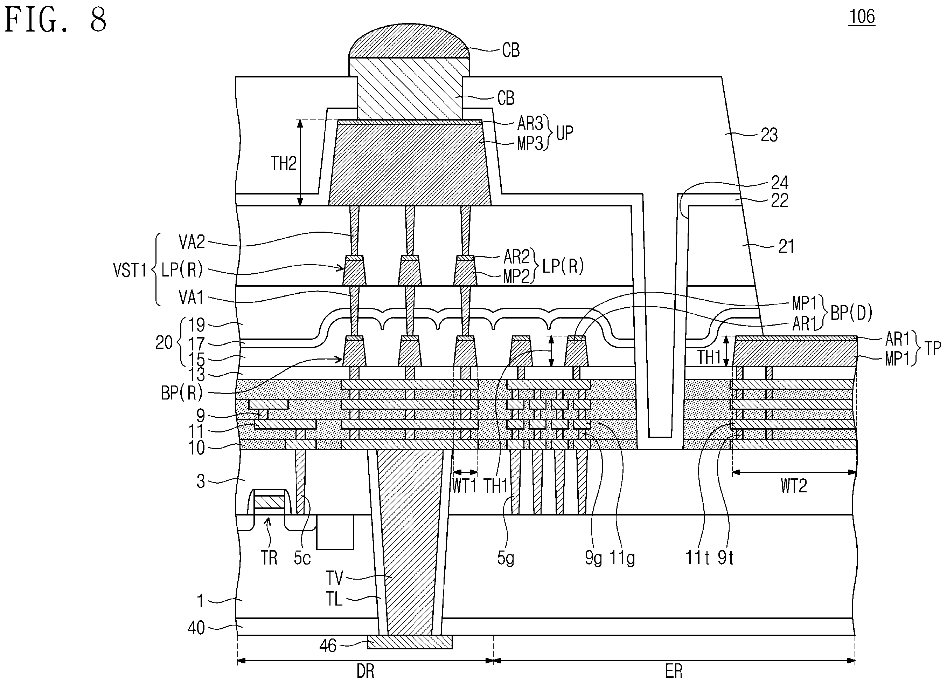

FIG. 8 is a cross-sectional view of a semiconductor chip according to embodiments of the inventive concept.

Referring to FIG. 8, a semiconductor chip 106 according to the present example further includes first residual test patterns 11t, first residual test vias 9t, and second residual test patterns TP. The first residual test patterns 11t and the first residual test vias 9t may be disposed in the porous insulating layers 10 in the second region ER. The first residual test patterns 11t may have the same thickness and the same material as the first wirings 11. The first residual test vias 9t may have the same thickness and the same material as the first vias 9. The second residual test pattern TP may have the same first thickness TH1 as the lower pad BP. A first thickness TH1 may be smaller than a second thickness TH2 of the upper pad UP. A lower surface of the second residual test pattern TP may have a width WT2 in the lateral direction that is wider than the first width WT1 of a lower surface of the lower pad BP.

The second residual test pattern TP may include a first metal portion MP1 and a first anti-reflection layer AR1 that are sequentially stacked. The first metal portion MP1 may be formed of aluminum, for example. The first anti-reflection layer AR1 may be formed of, for example, titanium nitride.

A portion of an upper surface of the second residual test pattern TP may be vertically overlapped by (e.g., covered with) a third interlayer insulating layer 20, a fourth interlayer insulating layer 21, a capping layer 22, and an upper passivation layer 23 that are sequentially stacked. Another portion of the upper surface of the second residual test pattern TP may be exposed. Sidewalls of the third interlayer insulating layer 20, the fourth interlayer insulating layer 21, the capping layer 22, and the upper passivation layer 23 may be aligned with each other. A trench 24 is formed in the porous insulating layers 10, the third interlayer insulating layer 20, and the fourth interlayer insulating layer 21 between the second residual test pattern TP and the lower pads BP.

A capping layer 22 may extend to cover an inner wall and a bottom surface of the trench 24. The capping layer 22 may extend to be interposed between the fourth interlayer insulating layer 21 and the upper passivation layer 23, and may cover side surfaces and a portion of the upper surface of the upper pad UP. The capping layer 22 may be formed of silicon oxide with a relatively higher density than that of the porous insulating layers 10. The capping layer 22 may penetrate the porous insulating layers 10 to impede/prevent physical cracks or moisture propagating from the outside of the semiconductor chip 106. A portion of the upper passivation layer 23 may be inserted into the trench 24 to fill the trench 24. Other structures may be the same/similar to those described with reference to FIG. 3.

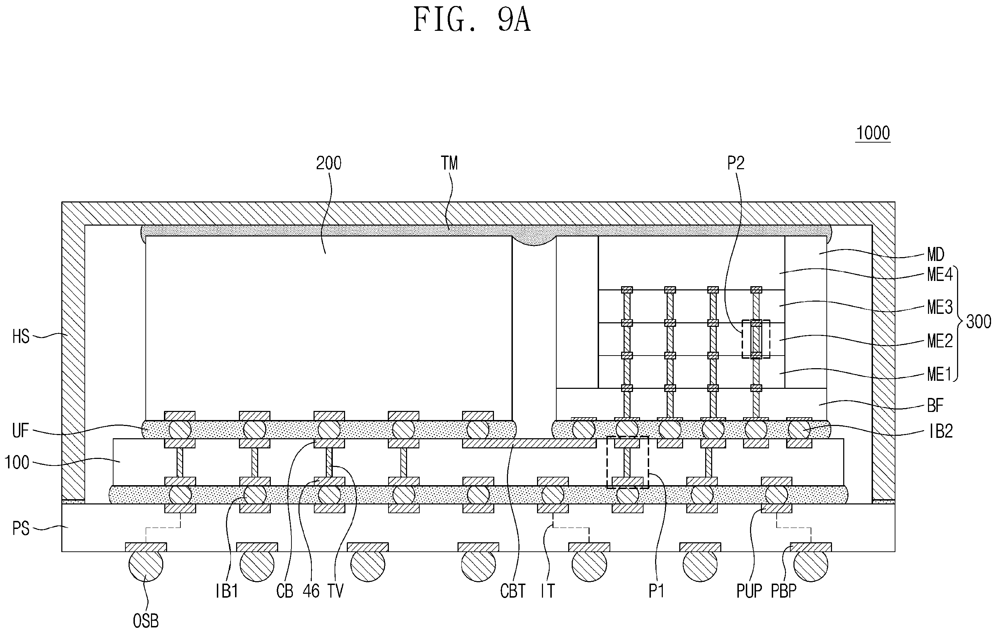

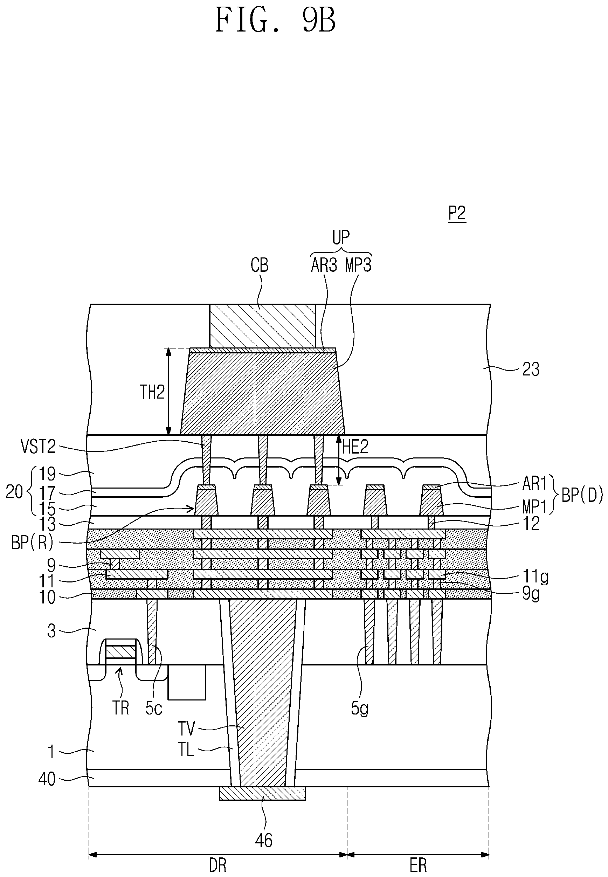

FIG. 9A is a cross-sectional view of a semiconductor package with a semiconductor chip according to embodiments of the inventive concept. FIG. 9B is an enlarged view of portion 'P2' of FIG. 9A.

Referring to FIGS. 1, 9A, and 9B, a semiconductor package 1000 according to the present example may include a package substrate PS, a first semiconductor chip 100, a second semiconductor chip 200, and a third semiconductor chip 300. The second semiconductor chip 200 and the third semiconductor chip 300 may be spaced apart from each other in a lateral direction, and may be on the first semiconductor chip 100. The package substrate PS may be a printed circuit board. The package substrate PS may include upper substrate pads PUP, lower substrate pads PBP, and internal substrate wirings IT electrically connecting them. External connection terminals OSB may be bonded to the lower substrate pads PBP.

The first semiconductor chip 100 may be mounted on the package substrate PS using first internal connecting members IB1. An underfill layer UF may be interposed between the package substrate PS and the first semiconductor chip 100. The first semiconductor chip 100 may also be called an 'interposer substrate' or an 'interposer chip.' The first semiconductor chip 100 may have the same structure as the semiconductor chip described with reference to FIG. 1. When portion 'P1' of the first semiconductor chip 100 is enlarged, the first semiconductor chip 100 may be the same as that in FIG. 1. The first semiconductor chip 100 may have the structure of the semiconductor chips described with reference to FIGS. 2A to 8 instead of the structure of FIG. 1. The first semiconductor chip 100 may include upper conductive bumps CB, lower conductive bumps 46, and through vias TV electrically connecting them. The first semiconductor chip 100 may further include an upper connection wiring CBT that electrically connects some of the upper conductive bumps CB.

The second semiconductor chip 200 and the third semiconductor chip 300 are mounted on the first semiconductor chip 100 by second internal connecting members IB2. An underfill layer UF may be interposed between the first semiconductor chip 100 and the second semiconductor chip 200 and between the first semiconductor chip 100 and the third semiconductor chip 300.

The underfill layer UF may be formed of a non-conductive film (NCF). The underfill layer UF may also be referred to as a 'non-conductive layer.' The underfill layer UF may independently include a thermosetting resin or a photocurable resin. Additionally, the underfill layer UF may further include an organic filler or an inorganic filler independently of each other. The organic filler may include, for example, a polymer material. The inorganic filler may include, for example, silicon oxide (SiO₂).

The second semiconductor chip 200 may be one selected from a system large scale integration (LSI) chip, a logic circuit chip, a microelectromechanical system (MEMS) device chip, or an application-specific integrated circuit (ASIC) chip. The third semiconductor chip 300 may be a high bandwidth memory (HBM) chip or a hybrid memory cubic (HMC) chip. The second semiconductor chip 200 and the third semiconductor chip 300 may be electrically connected to each other by the upper connection wiring CBT.

The third semiconductor chip 300 may include a buffer die BF and first to fourth memory dies ME1 to ME4 that are sequentially stacked. The third semiconductor chip 300 may further include a mold layer MD. For example, the mold layer MD may include an insulating resin such as epoxy-based molding compound (EMC). The mold layer MD may further include a filler, and the filler may be dispersed in the insulating resin.

Each of the first to fourth memory dies ME1 to ME4 may be, for example, a DRAM chip, SRAM chip, EEPROM chip, PRAM chip, MRAM chip, or ReRAM chip. Each of the buffer die BF and the first to fourth memory dies ME1 to ME4 may have the structure shown in FIG. 9B.

Specifically, referring to FIG. 9B, the buffer die BF and the first to fourth memory dies ME1 to ME4 may each have a structure similar to that of FIG. 1. To describe a structure different from that in FIG. 1, each of the buffer die BF and the first to fourth memory dies ME1 to ME4 excludes (i.e., omits) the fourth interlayer insulating layer 21 and includes a second via structure VST2 electrically connecting the first lower pads BP(R) and the upper pad UP.

The second via structure VST2 has a second height HE2 in the vertical direction. The second height HE2 is a vertical distance from a lowermost surface of the second via structure VST2 to an uppermost surface of the second via structure VST2. The second height HE2 may be equal to or smaller than a second thickness TH2 of the upper pad UP. The second height HE2 may be smaller than the first height HE1 of the first via structure VST1 of FIG. 1 belonging to the first semiconductor chip 100. The lower conductive bump 46 may be disposed in the lower passivation layer 40, and a lower surface of the lower conductive bump 46 may be coplanar with a lower surface of the lower passivation layer 40. An upper surface of the upper conductive bump CB may be coplanar with an upper surface of the upper passivation layer 23. Other structures may be the same/similar to those described with reference to FIG. 1.

The buffer die BF and the first to fourth memory dies ME1 to ME4 may each be bonded to each other using a Cu-to-Cu bonding manner. That is, the upper conductive bump CB of the buffer die BF and a lower one of the first to fourth memory dies ME1 to ME4 may be in contact with the buffer die BF and the lower conductive bump 46 of an upper one of the first to fourth memory dies ME1 to ME4.

In the semiconductor package 1000 with the semiconductor chip according to the inventive concept, a first height HE1 of the first via structure VST1 in the first semiconductor chip 100 corresponding to the interposer chip may be 1.0 µm to 10 µm. When testing performance of the third semiconductor chip 300, which is an HBM chip, using the interposer chip, resistance capacitance (RC) delay characteristics may be improved.

A heat dissipation member HS may be disposed on the second semiconductor chip 200 and the third semiconductor chip 300. The heat dissipation member HS may be a material with excellent thermal conductivity and may include, for example, metal. A thermal boundary material layer TM may be interposed between the heat dissipation member HS and the second semiconductor chip 200 and between the heat dissipation member HS and the third semiconductor chip 300. The thermal boundary material layer TM may include a thermosetting resin layer. The thermal boundary material layer TM may further include filler particles dispersed in the thermosetting resin layer. The filler particles may include at least one of silica, alumina, zinc oxide, and nitrogen boride.

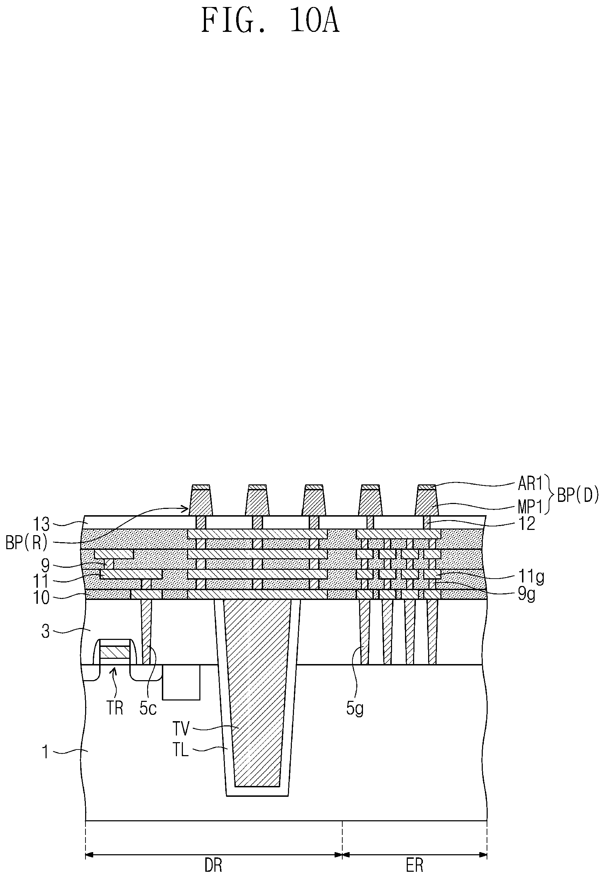

FIGS. 10A to 10G are views sequentially showing a method of manufacturing the semiconductor chip of FIG. 1.

Referring to FIG. 10A, transistors TR, first interlayer insulating layer 3, first contacts 5c, second contacts 5g, and first wirings 11, first vias 9, second wirings 11g, second vias 9g, porous insulating layers 10, through vias TV, via insulating layer TL, third vias 12 and a second interlayer insulating layer 13 are formed on a substrate 1 using a typical process. After the first metal layer and the first anti-reflection layer AR1 are sequentially deposited on the second interlayer insulating layer 13, an etching process is performed to form lower pads BP.

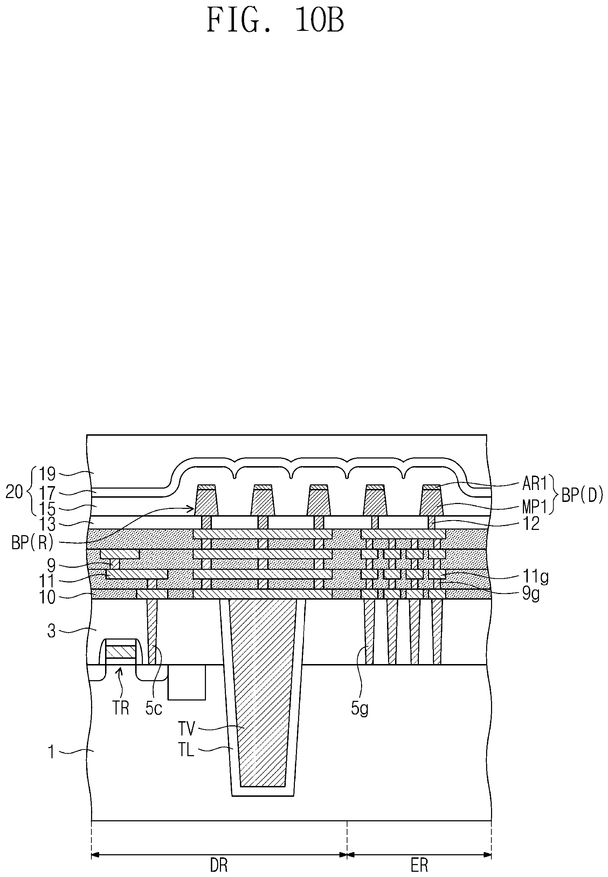

Referring to FIG. 10B, a first silicon oxide layer 15, a hydrogen barrier layer 17, and a second silicon oxide layer 19 are sequentially deposited on the lower pads BP to form a third interlayer insulating layer 20. A chemical mechanical polishing (CMP) process is performed to flatten an upper surface of the second silicon oxide layer 19.

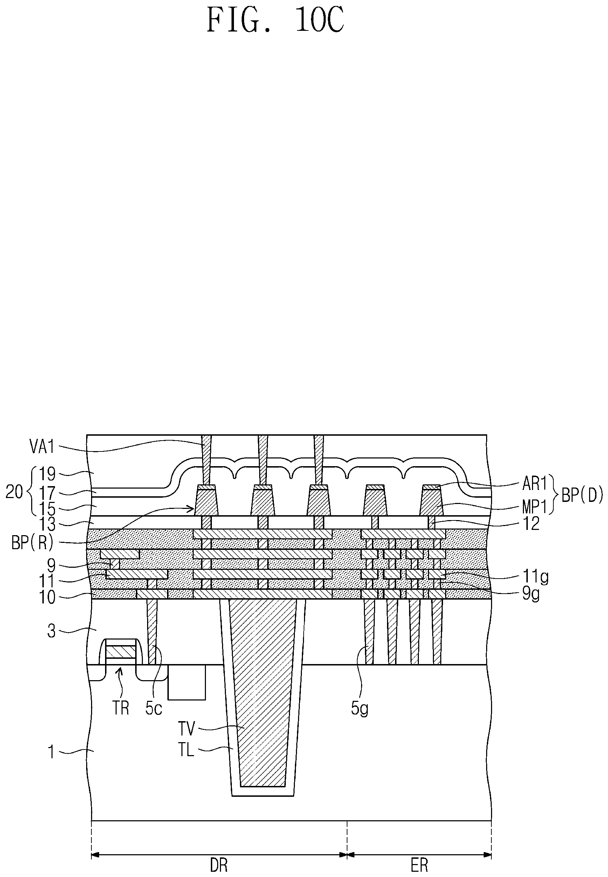

Referring to FIG. 10C, first via holes are formed in the third interlayer insulating layer 20. A conductive layer is deposited on the third interlayer insulating layer 20 to fill the first via holes, and an etch-back or CMP process is performed to form first vias VA1 in the third interlayer insulating layer 20.

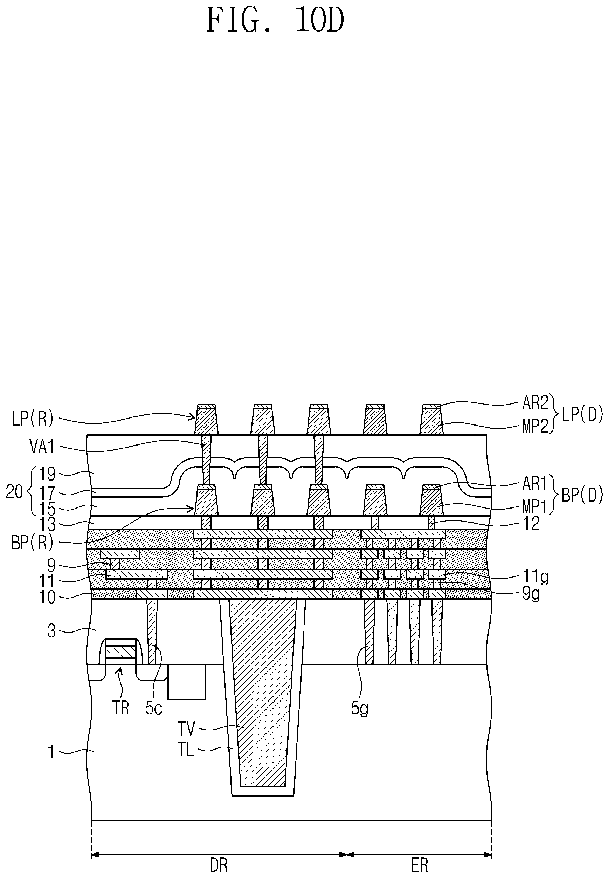

Referring to FIG. 10D, a second metal layer and a second anti-reflection layer AR2 are sequentially deposited on the third interlayer insulating layer 20 and etched to form landing pads LP. In this case, first landing pads LP(R) and second landing pads LP(D) may be formed simultaneously. The first landing pads LP(R) may be formed without defects by reducing/minimizing loading effect by using the second landing pads LP(D).

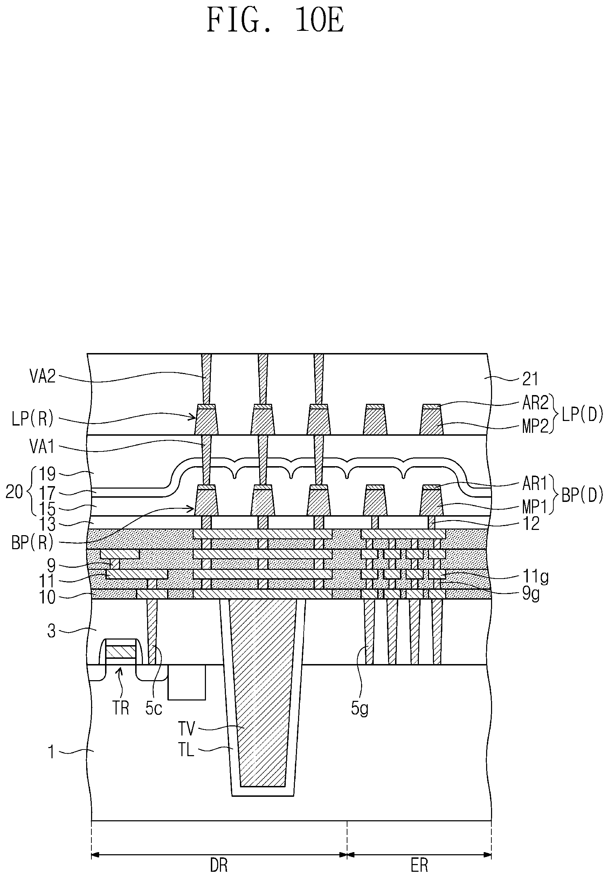

Referring to FIG. 10E, a fourth interlayer insulating layer 21 is formed on the third interlayer insulating layer 20. An upper surface of the fourth interlayer insulating layer 21 may be planarized by performing a CMP process. Second vias VA2 are formed in the fourth interlayer insulating layer 21. As a result, first via structures VST1 may be formed.

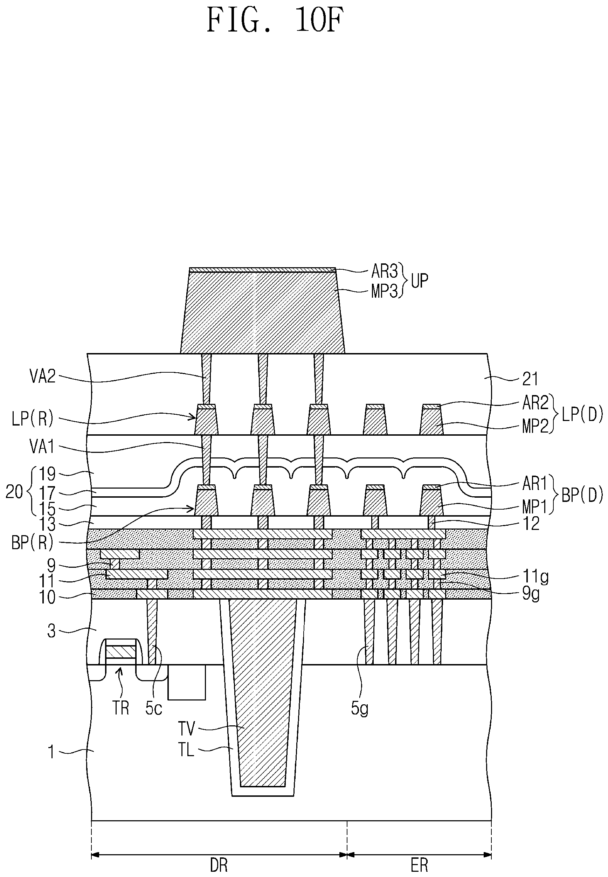

Referring to FIG. 10F, a third metal layer and a third antireflection layer AR3 are sequentially deposited on the fourth interlayer insulating layer 21 and then etched to form an upper pad UP.

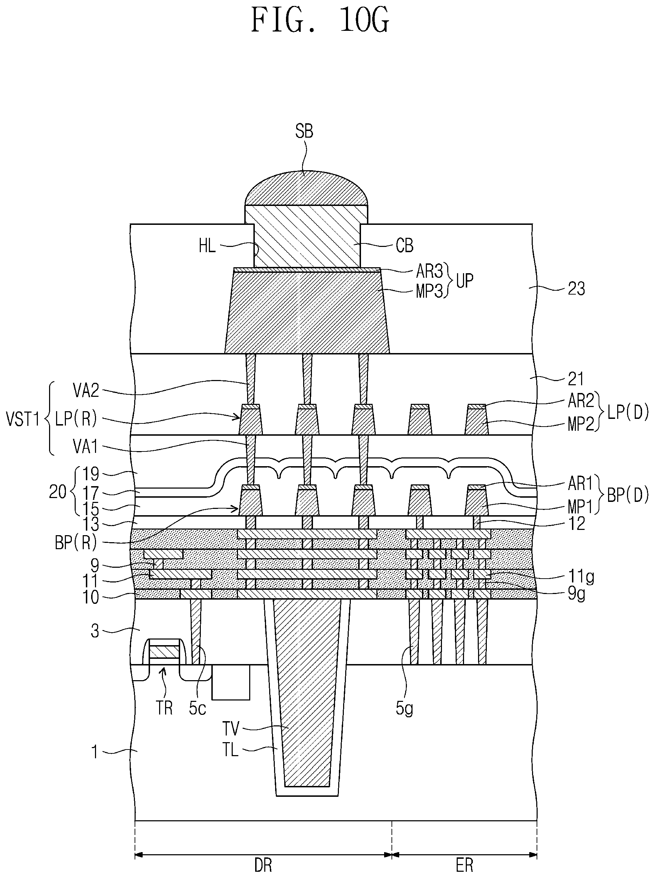

Referring to FIG. 10G, an upper passivation layer 23 is formed to cover the fourth interlayer insulating layer 21 and the upper pad UP. The upper passivation layer 23 is etched to form a hole HL exposing the upper pad UP. A conductive bump CB is formed in the hole HL and a solder layer SB is formed on the conductive bump CB.

Subsequently, referring to FIG. 1, a back grinding process is performed on a back surface of the substrate 1 to expose the through via TV. A lower passivation layer 40 and a lower conductive bump 46 are formed on the back surface of the substrate 1. Accordingly, the semiconductor chip 100 of FIG. 1 may be manufactured.

In the semiconductor chip according to embodiments of the inventive concept, the via structure electrically connecting the lower pad and the upper pad may have the height greater than the thickness of the upper pad, thereby improving the RC delay characteristics. Additionally, when testing the HBM chip using the interposer chip with the above-described structure, it may be very effective in improving the RC delay characteristics.

## Claims

1. A semiconductor chip comprising:
a substrate (1);
a first interlayer insulating layer (3), a porous insulating layer (10), and a second interlayer insulating layer (13) sequentially stacked on the substrate (1);
lower pads (BP) on the second interlayer insulating layer (13) and having a first thickness (TH1) in a vertical direction which is a direction perpendicular to an uppermost surface of the substrate (1);
third and fourth interlayer insulating layers (20, 21) sequentially stacked on the lower pads (BP) and the second interlayer insulating layer (13);
an upper pad (UP) on the fourth interlayer insulating layer (21) and having a second thickness (TH2) in the vertical direction greater than the first thickness (TH1); and
via structures (VST1) in both the fourth interlayer insulating layer (21) and the third interlayer insulating layer (20) and electrically connecting the lower pads (BP) and the upper pad (UP),
**characterised in that** each of the via structures (VST1) includes a first via (VA1) in the third interlayer insulating layer (20) and a second via (VA2) in the fourth interlayer insulating layer (21) and overlapping the first via (VA1) in the vertical direction.

2. The semiconductor chip of claim 1, wherein each of the via structures (VST1) has a height of 1.0 micrometers (µm) to 10 µm in the vertical direction that is greater than the second thickness (TH2).

3. The semiconductor chip of claim 1, wherein each of the via structures (VST1) further includes a landing pad (LP(R)) interposed between the first via (VA1) and the second via (VA2).

4. The semiconductor chip of claim 3,
wherein the landing pads (LP(R)) of the via structures (VST1) are spaced apart from each other and have circular shapes, or
wherein the landing pads (LP(R)) of the via structures (VST1) are electrically connected to each other to collectively have a perforated or non-perforated rectangular shape.

5. The semiconductor chip of claim 3, further comprising dummy pads (LP(D)) on the third interlayer insulating layer (20) and spaced apart from the landing pads (LP(R)),
wherein the dummy pads (LP(D)) are not electrically connected to the first via (VA1) and the second via (VA2) of any of the via structures (VST1).

6. The semiconductor chip of claim 5, wherein a first distance (DS1) in a lateral direction, which is a direction parallel to the uppermost surface of the substrate (1), between the landing pads (LP(R)) is equal to a second distance in the lateral direction between the dummy pads (LP(D)).

7. The semiconductor chip of claim 6,
wherein the landing pads (LP(R)) include an outermost landing pad (LP(R1)) adjacent to the dummy pads (LP(D)),
wherein the dummy pads (LP(D)) include an outermost dummy pad (LP(D1)) adjacent to the outermost landing pad (LP(R1)), and
wherein a third distance in the lateral direction between the outermost landing pad (LP(R1)) and the outermost dummy pad (LP(D1)) is equal to the first distance (DS1).

8. The semiconductor chip of claim 6, wherein a first width (WT1) in the lateral direction of each of the landing pads (LP(R)) is equal to a second width in the lateral direction of each of the dummy pads (LP(D)).

9. The semiconductor chip of claim 1,
wherein the fourth interlayer insulating layer (21) includes a first silicon oxide layer (15), a hydrogen barrier layer (17), and a second silicon oxide layer (19) that are sequentially stacked, and
wherein the first via (VA1) is in the first silicon oxide layer (15), the hydrogen barrier layer (17), and the second silicon oxide layer (19).

10. The semiconductor chip of claim 1,
wherein the second via (VA2) is in contact with the first via (VA1),
wherein a lower width in a lateral direction, which is a direction parallel to the uppermost surface of the substrate (1), of each of the first via (VA1) and the second via (VA2) is narrower than an upper width in the lateral direction of each of the first via (VA1) and the second via (VA2),
wherein a portion of an upper surface of the first via (VA1) protrudes in the lateral direction beyond a lower surface of the second via (VA2), and
wherein the fourth interlayer insulating layer (21) is on the portion of the upper surface of the first via (VA1).

11. The semiconductor chip of claim 1, wherein each of the via structures (VST1) further includes a third via on the second via (VA2).

12. The semiconductor chip of claim 11,
wherein each of the via structures (VST1) further includes a landing pad (LP(R)), and
wherein the landing pad (LP(R)) is between the first via (VA1) and the second via (VA2), or is between the second via (VA2) and the third via.

13. The semiconductor chip of claim 1, further comprising:
wirings (9, 11) in the porous insulating layer (10);
first residual test patterns (11t) in the porous insulating layer (10) and spaced apart in a lateral direction, which is a direction parallel to the uppermost surface of the substrate (1), from the wirings (9, 11); and
a second residual test pattern (TP) on the second interlayer insulating layer (13), electrically connected to the first residual test patterns (11t), and spaced apart in the lateral direction from the lower pads (BP),
wherein the second residual test pattern (TP) has the first thickness (TH1), and
wherein a width in the lateral direction of the second residual test pattern (TP) is greater than a width in the lateral direction of each of the lower pads (BP).

14. The semiconductor chip of claim 13, further comprising:
a capping layer (22) on the fourth interlayer insulating layer (21) and on side and upper surfaces of the upper pad (UP); and
a passivation layer (23) on the capping layer (22),
wherein a portion of the capping layer (22) is in the fourth interlayer insulating layer (21), the third interlayer insulating layer (20), the second interlayer insulating layer (13), and the porous insulating layer (10), and is in contact with the first interlayer insulating layer (3).

15. The semiconductor chip of claim 14, further comprising a conductive bump (CB) that is in the passivation layer (23) and the capping layer (22), and is in contact with the upper pad (UP).

## Patentansprüche

1. Halbleiter-Chipelement, aufweisend:
ein Substrat (1);
eine erste Zwischenschicht-Isolierschicht (3), eine poröse Isolierschicht (10) und eine zweite Zwischenschicht-Isolierschicht (13), die nacheinander auf dem Substrat (1) gestapelt sind;
untere Pads (BP) auf der zweiten Zwischenschicht-Isolierschicht (13) mit einer ersten Dicke (TH1) in einer vertikalen Richtung, die eine Richtung senkrecht zu einer obersten Oberfläche des Substrats (1) ist;
dritte und vierte Zwischenschicht-Isolierschichten (20, 21), die nacheinander auf den unteren Pads (BP) und der zweiten Zwischenschicht-Isolierschicht (13) gestapelt sind;
ein oberes Pad (UP) auf der vierten Zwischenschicht-Isolierschicht (21) mit einer zweiten Dicke (TH2) in der vertikalen Richtung, welcher größer als die erste Dicke (TH1) ist; und
Durchkontaktierungsstrukturen (VST1) sowohl in der vierten Zwischenschicht-Isolierschicht (21) als auch in der dritten Zwischenschicht-Isolierschicht (20), die die unteren Pads (BP) und das obere Pad (UP) elektrisch verbinden,
**dadurch gekennzeichnet, dass** jede der Durchkontaktierungsstrukturen (VST1) eine erste Durchkontaktierung (VA1) in der dritten Zwischenschicht-Isolierschicht (20) und eine zweite Durchkontaktierung (VA2) in der vierten Zwischenschicht-Isolierschicht (21) beinhaltet und die erste Durchkontaktierung (VA1) in der vertikalen Richtung überlappt.

2. Halbleiter-Chipelement nach Anspruch 1, wobei jede der Durchkontaktierungsstrukturen (VST1) eine Höhe von 1,0 Mikrometern (µm) bis 10 µm in der vertikalen Richtung aufweist, welche größer als die zweite Dicke (TH2) ist.

3. Halbleiter-Chipelement nach Anspruch 1, wobei jede der Durchkontaktierungsstrukturen (VST1) ferner eine Anschluss-Pad (LP(R)) beinhaltet, welches zwischen der ersten Durchkontaktierung (VA1) und der zweiten Durchkontaktierung (VA2) angeordnet ist.

4. Halbleiter-Chipelement nach Anspruch 3,
wobei die Anschluss-Pads (LP(R)) der Durchkontaktierungsstrukturen (VST1) voneinander beabstandet sind und kreisförmige Formen aufweisen, oder
wobei die Anschluss-Pads (LP(R)) der Durchkontaktierungsstrukturen (VST1) elektrisch miteinander verbunden sind, um gemeinsam eine perforierte oder nicht perforierte rechteckige Form aufzuweisen.

5. Halbleiter-Chipelement nach Anspruch 3, der ferner Dummy-Pads (LP(D)) auf der dritten Zwischenschicht-Isolierschicht (20) aufweist, die von den Anschluss-Pads (LP(R)) beabstandet sind,
wobei die Dummy-Pads (LP(D)) mit der ersten Durchkontaktierung (VA1) und der zweiten Durchkontaktierung (VA2) von einer der Durchkontaktierungsstrukturen (VST1) nicht elektrisch verbunden sind.

6. Halbleiter-Chipelement nach Anspruch 5, wobei ein erster Abstand (DS1) in einer seitlichen Richtung, die eine Richtung parallel zu der obersten Oberfläche des Substrats (1) ist, zwischen den Anschluss-Pads (LP(R)) gleich einem zweiten Abstand in der seitlichen Richtung zwischen den Dummy-Pads (LP(D)) ist.

7. Halbleiter-Chipelement nach Anspruch 6,
wobei die Anschluss-Pads (LP(R)) ein äußerstes Anschluss-Pad (LP(R1)) beinhalten, das an die Dummy-Pads (LP(D)) angrenzt,
wobei die Dummy-Pads (LP(D)) ein äußerstes Dummy-Pad (LP(D1)) beinhalten, das an das äußerste Anschluss-Pad (LP(R1)) angrenzt, und
wobei ein dritter Abstand in der seitlichen Richtung zwischen dem äußersten Anschluss-Pad (LP(R1)) und dem äußersten Dummy-Pad (LP(D1)) gleich dem ersten Abstand (DS1) ist.

8. Halbleiter-Chipelement nach Anspruch 6, wobei eine erste Breite (WT1) in der seitlichen Richtung jedes der Anschluss-Pads (LP(R)) gleich einer zweiten Breite in der seitlichen Richtung jedes der Dummy-Pads (LP(D)) ist.

9. Halbleiter-Chipelement nach Anspruch 1,
wobei die vierte Zwischenschicht-Isolierschicht (21) eine erste Siliziumoxidschicht (15), eine Wasserstoffbarriereschicht (17) und eine zweite Siliziumoxidschicht (19) umfasst, die nacheinander gestapelt sind, und
wobei die erste Durchkontaktierung (VA1) in der ersten Siliziumoxidschicht (15), der Wasserstoffbarriereschicht (17) und der zweiten Siliziumoxidschicht (19) angeordnet ist.

10. Halbleiter-Chipelement nach Anspruch 1,
wobei die zweite Durchkontaktierung (VA2) mit der ersten Durchkontaktierung (VA1) in Kontakt steht,
wobei eine untere Breite in einer seitlichen Richtung, die eine Richtung parallel zu der obersten Oberfläche des Substrats (1) ist, von jeweils der ersten Durchkontaktierung (VA1) und der zweiten Durchkontaktierung (VA2) schmaler ist als eine obere Breite in der seitlichen Richtung von jeweils der ersten Durchkontaktierung (VA1) und der zweiten Durchkontaktierung (VA2),
wobei ein Abschnitt einer oberen Oberfläche der ersten Durchkontaktierung (VA1) in der seitlichen Richtung über eine untere Oberfläche der zweiten Durchkontaktierung (VA2) hinausragt, und
wobei sich die vierte Zwischenschicht-Isolierschicht (21) auf dem Abschnitt der oberen Oberfläche der ersten Durchkontaktierung (VA1) befindet.

11. Halbleiter-Chipelement nach Anspruch 1, wobei jede der Durchkontaktierungsstrukturen (VST1) ferner eine dritte Durchkontaktierung auf der zweiten Durchkontaktierung (VA2) umfasst.

12. Halbleiter-Chipelement nach Anspruch 11,
wobei jede der Durchkontaktierungsstrukturen (VST1) ferner ein Anschluss-Pad (LP(R)) umfasst, und
wobei sich das Anschluss-Pad (LP(R)) zwischen der ersten Durchkontaktierung (VA1) und der zweiten Durchkontaktierung (VA2) oder zwischen der zweiten Durchkontaktierung (VA2) und der dritten Durchkontaktierung befindet.

13. Halbleiter-Chipelement nach Anspruch 1, das ferner aufweist:
Verdrahtungen (9, 11) in der porösen Isolierschicht (10);
erste Rückstandstestmuster (11t) in der porösen Isolierschicht (10), die in einer seitlichen Richtung, die eine Richtung parallel zu der obersten Oberfläche des Substrats (1) ist, von den Verdrahtungen (9, 11) beabstandet sind; und
ein zweites Rückstandstestmuster (TP) auf der zweiten Zwischenschicht-Isolierschicht (13), das mit den ersten Rückstandstestmustern (11t) verbunden ist und in der seitlichen Richtung von den unteren Pads (BP) beabstandet ist,
wobei das zweite Rückstandstestmuster (TP) die erste Dicke (TH1) aufweist und
wobei eine Breite in der seitlichen Richtung des zweiten Rückstandstestmusters (TP) größer ist als eine Breite in der seitlichen Richtung eines jeweiligen der unteren Pads (BP).

14. Halbleiter-Chipelement nach Anspruch 13, ferner aufweisend:
eine Abdeckschicht (22) auf der vierten Zwischenschicht-Isolierschicht (21) und auf den seitlichen und oberen Oberflächen des oberen Pads (UP); und
eine Passivierungsschicht (23) auf der Abdeckschicht (22),
wobei sich ein Abschnitt der Abdeckschicht (22) in der vierten Zwischenschicht-Isolierschicht (21), der dritten Zwischenschicht-Isolierschicht (20), der zweiten Zwischenschicht-Isolierschicht (13) und der porösen Isolierschicht (10) befindet und mit der ersten Zwischenschicht-Isolierschicht (3) in Kontakt steht.

15. Halbleiter-Chipelement nach Anspruch 14, ferner aufweisend eine leitfähige Lötkugel (CB), die sich in der Passivierungsschicht (23) und der Abdeckschicht (22) befindet und mit dem oberen Pad (UP) in Kontakt steht.

## Revendications

1. Puce semi-conductrice comprenant :
un substrat (1) ;
une première couche isolante inter-couche (3), une couche isolante poreuse (10) et une deuxième couche isolante inter-couche (13) empilées séquentiellement sur le substrat (1) ;
des plots inférieurs (BP) sur la deuxième couche isolante inter-couche (13) et présentant une première épaisseur (TH1) selon une direction verticale, ladite direction verticale étant perpendiculaire à une surface supérieure du substrat (1) ;
des troisième et quatrième couches isolantes inter-couches (20, 21) empilées séquentiellement sur les plots inférieurs (BP) et la deuxième couche isolante inter-couche (13) ;
un plot supérieur (UP) sur la quatrième couche isolante inter-couche (21) et présentant une deuxième épaisseur (TH2) selon la direction verticale, supérieure à la première épaisseur (TH1) ; et
des structures de via (VST1) à la fois dans la quatrième couche isolante inter-couche (21) et dans la troisième couche isolante inter-couche (20) et reliant électriquement les plots inférieurs (BP) et le plot supérieur (UP),
**caractérisée en ce que** chacune des structures de via (VST1) comprend un premier via (VA1) dans la troisième couche isolante inter-couche (20) et un deuxième via (VA2) dans la quatrième couche isolante inter-couche (21), ledit deuxième via (VA2) étant superposé au premier via (VA1) selon la direction verticale.

2. Puce semi-conductrice selon la revendication 1, dans laquelle chacune des structures de via (VST1) présente, selon la direction verticale, une hauteur comprise entre 1,0 µm et 10 µm, ladite hauteur étant supérieure à la deuxième épaisseur (TH2).

3. Puce semi-conductrice selon la revendication 1, dans laquelle chacune des structures de via (VST1) comprend en outre un plot d'atterrissage (LP(R)) interposé entre le premier via (VA1) et le deuxième via (VA2).

4. Puce semi-conductrice selon la revendication 3,
dans laquelle les plots d'atterrissage (LP(R)) des structures de via (VST1) sont espacés les uns des autres et ont des formes circulaires, ou
dans laquelle les plots d'atterrissage (LP(R)) des structures de via (VST1) sont reliés électriquement les uns aux autres de manière à former collectivement une forme rectangulaire perforée ou non perforée.

5. Puce semi-conductrice selon la revendication 3, comprenant en outre des plots factices (LP(D)) sur la troisième couche isolante inter-couche (20) et espacés des plots d'atterrissage (LP(R)),
dans laquelle les plots factices (LP(D)) ne sont reliés électriquement ni au premier via (VA1) ni au deuxième via (VA2) d'aucune des structures de via (VST1).

6. Puce semi-conductrice selon la revendication 5, dans laquelle une première distance (DS1), selon une direction latérale, ladite direction latérale étant parallèle à la surface supérieure du substrat (1), entre les plots d'atterrissage (LP(R)) est égale à une deuxième distance, selon la direction latérale, entre les plots factices (LP(D)).

7. Puce semi-conductrice selon la revendication 6,
dans laquelle les plots d'atterrissage (LP(R)) comprennent un plot d'atterrissage situé le plus à l'extérieur (LP(R1)) adjacent aux plots factices (LP(D)),
dans laquelle les plots factices (LP(D)) comprennent un plot factice situé le plus à l'extérieur (LP(D1)) adjacent au plot d'atterrissage le plus externe (LP(R1)), et
dans laquelle une troisième distance, selon la direction latérale, entre le plot d'atterrissage le plus externe (LP(R1)) et le plot factice le plus externe (LP(D1)) est égale à la première distance (DS1).

8. Puce semi-conductrice selon la revendication 6, dans laquelle une première largeur (WT1), selon la direction latérale, de chacun des plots d'atterrissage (LP(R)) est égale à une deuxième largeur, selon la direction latérale, de chacun des plots factices (LP(D)).

9. Puce semi-conductrice selon la revendication 1,
dans laquelle la quatrième couche isolante inter-couche (21) comprend une première couche d'oxyde de silicium (15), une couche barrière à hydrogène (17) et une deuxième couche d'oxyde de silicium (19) empilées séquentiellement, et
dans laquelle le premier via (VA1) se trouve dans la première couche d'oxyde de silicium (15), la couche barrière à hydrogène (17) et la deuxième couche d'oxyde de silicium (19).

10. Puce semi-conductrice selon la revendication 1,
dans laquelle le deuxième via (VA2) est en contact avec le premier via (VA1),
dans laquelle une largeur inférieure, selon une direction latérale, ladite direction latérale étant parallèle à la surface supérieure du substrat (1), de chacun du premier via (VA1) et du deuxième via (VA2) est plus étroite qu'une largeur supérieure, selon la direction latérale, de chacun du premier via (VA1) et du deuxième via (VA2),
dans laquelle une portion d'une surface supérieure du premier via (VA1) dépasse, selon la direction latérale, au-delà d'une surface inférieure du deuxième via (VA2), et
dans laquelle la quatrième couche isolante inter-couche (21) est sur ladite portion de la surface supérieure du premier via (VA1).

11. Puce semi-conductrice selon la revendication 1, dans laquelle chacune des structures de via (VST1) comprend en outre un troisième via sur le deuxième via (VA2).

12. Puce semi-conductrice selon la revendication 11,
dans laquelle chacune des structures de via (VST1) comprend en outre un plot d'atterrissage (LP(R)), et
dans laquelle le plot d'atterrissage (LP(R)) est entre le premier via (VA1) et le deuxième via (VA2), ou est entre le deuxième via (VA2) et le troisième via.

13. Puce semi-conductrice selon la revendication 1, comprenant en outre :
des interconnexions (9, 11) dans la couche isolante poreuse (10) ;
des premiers motifs d'essai résiduels (11t) dans la couche isolante poreuse (10) et espacés, selon une direction latérale, ladite direction latérale étant parallèle à la surface supérieure du substrat (1), des interconnexions (9, 11) ; et
un deuxième motif d'essai résiduel (TP) sur la deuxième couche isolante inter-couche (13), relié électriquement aux premiers motifs d'essai résiduels (11t), et espacé, selon la direction latérale, des plots inférieurs (BP),
dans laquelle le deuxième motif d'essai résiduel (TP) présente la première épaisseur (TH1), et
dans laquelle une largeur, selon la direction latérale, du deuxième motif d'essai résiduel (TP) est supérieure à une largeur, selon la direction latérale, de chacun des plots inférieurs (BP).

14. Puce semi-conductrice selon la revendication 13, comprenant en outre :
une couche de recouvrement (22) sur la quatrième couche isolante inter-couche (21) et sur des surfaces latérales et supérieures du plot supérieur (UP) ; et
une couche de passivation (23) sur la couche de recouvrement (22),
dans laquelle une portion de la couche de recouvrement (22) est située dans la quatrième couche isolante inter-couche (21), la troisième couche isolante inter-couche (20), la deuxième couche isolante inter-couche (13) et la couche isolante poreuse (10), et est en contact avec la première couche isolante inter-couche (3).

15. Puce semi-conductrice selon la revendication 14, comprenant en outre un bump conducteur (CB) qui est dans la couche de passivation (23) et la couche de capotage (22), et est en contact avec le plot supérieur (UP).
